Europäisches Patentamt

European Patent Office

Office européen des brevets

(19)

(11) Numéro de publication : **0 119 917**
**B1**

(12) **FASCICULE DE BREVET EUROPÉEN**

(45) Date de publication du fascicule du brevet :
16.06.87

(51) Int. Cl.⁴ : **H 01 L 21/90**, H 01 L 21/60

(21) Numéro de dépôt : **84400506.6**

(22) Date de dépôt : **13.03.84**

(54) **Procédé de positionnement d'une ligne d'interconnexion sur un trou de contact électrique d'une circuit intégré.**

(30) Priorité : **18.03.83 FR 8304472**

(43) Date de publication de la demande :
**26.09.84 Bulletin 84/39**

(45) Mention de la délivrance du brevet :
**16.06.87 Bulletin 87/25**

(84) Etats contractants désignés :
**DE GB IT NL**

(56) Documents cités :
**DE-A- 1 806 980**
**DE-A- 2 723 933**
**DE-A- 2 740 757**
**US-A- 4 062 720**

(73) Titulaire : **COMMISSARIAT A L'ENERGIE ATOMIQUE**
**Etablissement de Caractère Scientifique Technique**
**et Industriel**
**31/33, rue de la Fédération**
**F-75015 Paris (FR)**

(72) Inventeur : **Jeuch, Pierre**
**49, Avenue Louis Armand**
**F-38170 Seyssins (FR)**
Inventeur : **Lazzari, Jean-Pierre**
**45, Chemin de Malanot**
**F-38700 Corenc (FR)**
Inventeur : **Parrens, Pierre**
**Tour Mont Blanc 15, Boulevard Maréchal Leclerc**
**F-38000 Grenoble (FR)**

(74) Mandataire : **Mongrédien, André et al**
**c/o BREVATOME 25, rue de Ponthieu**
**F-75008 Paris (FR)**

## Description

La présente invention a pour objet un procédé de positionnement d'une ligne d'interconnexion sur un trou de contact électrique d'un circuit intégré. Ce procédé de positionnement est utilisable, en particulier, dans les procédés de fabrication de circuits intégrés MOS (Métal-Oxyde-Semiconducteur).

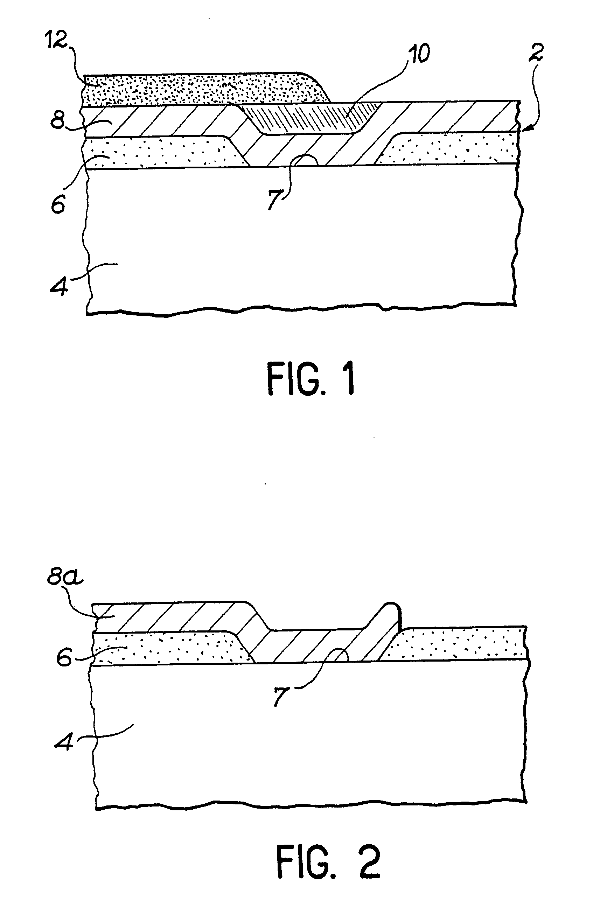

Sur la figure 1, on a représenté en coupe, selon l'art antérieur, une étape du procédé de positionnement d'une ligne d'interconnexion sur un trou de contact électrique d'un circuit intégré. Le circuit intégré, portant la référence générale 2, comprend une zone active 4, semiconductrice dopée, correspondant par exemple à la source ou au drain d'un transistor MOS, devant être connectée électriquement à une autre zone active (non représentée) du circuit intégré. Cette zone active 4 est recouverte d'une couche d'oxyde 6 dans laquelle on réalise le trou de contact électrique 7 de cette zone active 4, en gravant la couche d'oxyde 6 par attaque chimique à travers un masque approprié disposé sur cette couche. L'interconnexion de la zone active 4 et de l'autre zone active du circuit intégré est réalisée en recouvrant l'ensemble du circuit intégré d'une couche conductrice 8, puis en gravant cette couche. Cette couche 8 étant d'épaisseur constante, forme un creux au-dessus du trou de contact électrique 7.

Pour réaliser la ligne d'interconnexion 8a (visible sur la figure 2), on dépose sur la couche conductrice 8 une couche d'isolant 10 qui est ensuite gravée de manière à ne subsister que dans le creux situé au-dessus du trou de contact électrique 7. On réalise ensuite un masque de gravure dans une couche de résine 12. La couche conductrice 8 est ensuite gravée, par exemple de façon isotrope par une simple attaque chimique ou de façon anisotrope par un plasma contenant des composés tels que CCl$_4$. Les résines sont ensuite éliminées. On obtient alors la ligne d'interconnexion 8a représentée en coupe sur la figure 2.

Ce procédé permet de réaliser des lignes d'interconnexion sur un trou de contact électrique sans que leslignes d'interconnexion ne débordent du trou de contact électrique.

L'objet de la présente invention est de simplifier ce procédé. Le procédé décrit nécessite l'utilisation de deux couches de résine. Un avantage de la présente invention est de ne nécessiter qu'une seule couche de résine. Il permet de réaliser des lignes d'interconnexion dont la largeur n'est pas plus importante que le diamètre du trou de contact électrique ce qui augmente la densité d'intégration.

De manière plus précise, l'invention a pour objet un procédé de positionnement d'une ligne d'interconnexion sur un trou de contact électrique d'un circuit intégré dans lequel le trou de contact électrique étant réalisé, les bords du trou de contact étant sensiblement perpendiculaires à la surface du circuit intégré, on effectue les opérations suivantes :

dépôt sur l'ensemble du circuit intégré d'au moins une couche conductrice, l'ensemble de ces couches conductrices formant un revêtement conducteur, remplissant le trou de contact et présentant une surface sensiblement plane après dépôt, dans lequel sera réalisée la ligne d'interconnexion, le dépôt de la première couche conductrice étant un dépôt isotrope,

réalisation sur le revêtement conducteur d'une couche de résine de façon à masquer la ligne d'interconnexion à réaliser,

réalisation d'une gravure de la partie du revêtement conducteur dépourvue de résine,

réalisation d'une surgravure, dans le trou de contact électrique, de la partie du revêtement conducteur dépourvue de résine,

élimination de la résine.

La première couche conductrice est la couche inférieure du revêtement conducteur. Elle est directement en contact avec le fond du trou de contact électrique. La surgravure assure que la surface libre du revêtement conducteur est dans le trou de contact électrique.

Selon un mode préféré de mise en œuvre du procédé, le revêtement conducteur est constitué d'une seule couche conductrice.

Selon un mode de mise en œuvre avantageux de l'invention, la gravure de la couche conductrice est une gravure sèche.

Selon une autre mode préféré de mise en œuvre du procédé selon l'invention, le revêtement conducteur est constitué d'une pluralité de couches conductrices.

Selon un mode de mise en œuvre préféré du procédé selon l'invention, toutes les couches conductrices sont gravées au moyen du même masque.

Selon un mode de mise en œuvre avantageux de l'invention, la gravure de la première couche conductrice est sélective par rapport à celle de la deuxième couche conductrice.

Selon un mode de mise en œuvre avantageux de l'invention, la gravure de la première couche conductrice est une gravure sèche.

Selon un mode de mise en œuvre avantageux de l'invention, la première couche est une couche de semiconducteur dopé.

Selon un autre mode préféré de mise en œuvre du procédé selon l'invention, le revêtement conducteur est constitué de deux couches conductrices.

Selon un mode de mise en œuvre avantageux de l'invention, la deuxième couche conductrice est une couche métallique.

D'autres caractéristiques et avantages de l'invention ressortiront mieux de la description qui va suivre, donnée à titre illustratif mais nullement limitatif, en référence aux figures annexées selon lesquelles :

les figures 1 et 2 déjà décrites, représentent respectivement une étape du procédé de positionnement d'une ligne d'interconnexion sur un trou de contact d'un circuit intégré et la ligne d'interconnexion obtenue par ce procédé, selon l'art antérieur,

les figures 3a à 3d représentent, schématiquement, les différentes étapes du procédé de positionnement conformément à l'invention dans le cas d'une ligne d'interconnexion monocouche,

les figures 4a à 4d représentent, schématiquement, les différentes étapes du procédé de positionnement, conformément à l'invention, d'une ligne d'interconnexion multicouche.

Sur la figure 3a on a représenté une partie d'un circuit intégré comprenant une zone active 14, semiconductrice dopée, correspondant par exemple à la source ou au drain d'un transistor MOS que l'on veut connecter électriquement à une autre zone active (non représentée) du circuit intégré. De façon classique, cette zone active 14 est recouverte d'une couche isolante 16, généralement réalisée en silice pouvant contenir 5 à 10 % de phosphore. Cette couche de silice présente par exemple une épaisseur de 0,8 $\mu$m. Cette couche de silice 16 est ensuite gravée, en utilisant un masque de résine réalisé par photolithographie sur cette couche, par exemple par une gravure ionique réactive avec $CHF_3$ de façon à réaliser le trou de contact électrique 17 de la zone active 14.

Après réalisation du trou de contact électrique 17, on dépose sur l'ensemble du circuit intégré, par un procédé isotrope, une couche conductrice 18, réalisée de préférence en aluminium. Cette couche conductrice 18 présente une épaisseur constante, par exemple voisine de 1 $\mu$. On peut par exemple employer comme procédé de dépôt isotrope la pulvérisation magnétron ou l'évaporation avec un planétaire. Ces deux procédés sont partiellement isotropes. Il convient donc, pour combler le trou de contact électrique 17, que l'épaisseur de la couche conductrice 18 soit supérieure au rayon du trou de contact électrique 17.

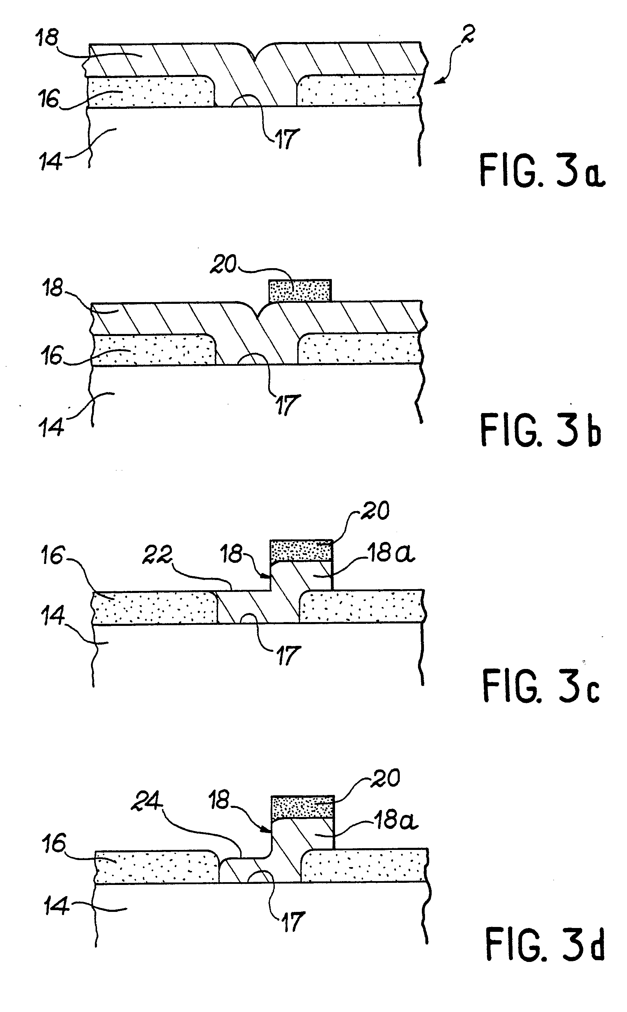

On dépose ensuite une couche de résine photosensible 20 dans laquelle on réalise l'image de la ligne d'interconnexion à réaliser selon les procédés classiques de la photolithographie, c'est-à-dire par masquage de la ligne d'interconnexion à réaliser. Le masque de la ligne d'interconnexion est visible en coupe transversale sur la figure 3b. L'axe vertical de cette ligne et l'axe du trou de contact 17 ne sont pas confondus. Ils peuvent être en pratique distants jusqu'à environ 0,4 $\mu$m à cause de l'imprécision de superposition des niveaux de masquage successifs dans le cas d'une technologie micronique.

Comme représenté sur la figure 3c, l'étape suivante du procédé de positionnement consiste à graver la partie de la couche conductrice 18 dépourvue de la couche de résine 20. De manière préférée, on utilise un procédé de gravure sèche, de préférence anisotrope, par exemple un plasma comprenant des composés tels que $CCl_4$. Ce procédé de gravure permet un très bon contrôle de fin d'attaque. On peut donc réaliser une surgravure très précise de la couche conductrice 18 de manière à obtenir le profil représenté sur la figure 3d. Cette surgravure assure que la surface 24 de la couche conductrice 18 non recouverte par la couche de résine 20, se trouve en retrait par rapport à la surface de la couche isolante 16. Cette surgravure permet d'assurer une bonne séparation des lignes conductrices.

La dernière étape du procédé consiste à éliminer la couche de résine 20, en utilisant, par exemple, un plasma d'oxygène.

Ce procédé permet de réaliser des largeurs de lignes d'interconnexion et des diamètres de trous de contact électrique de l'ordre de 1 $\mu$m pour une précision de superposition des niveaux de masques successifs de l'ordre de 0,4 $\mu$m.

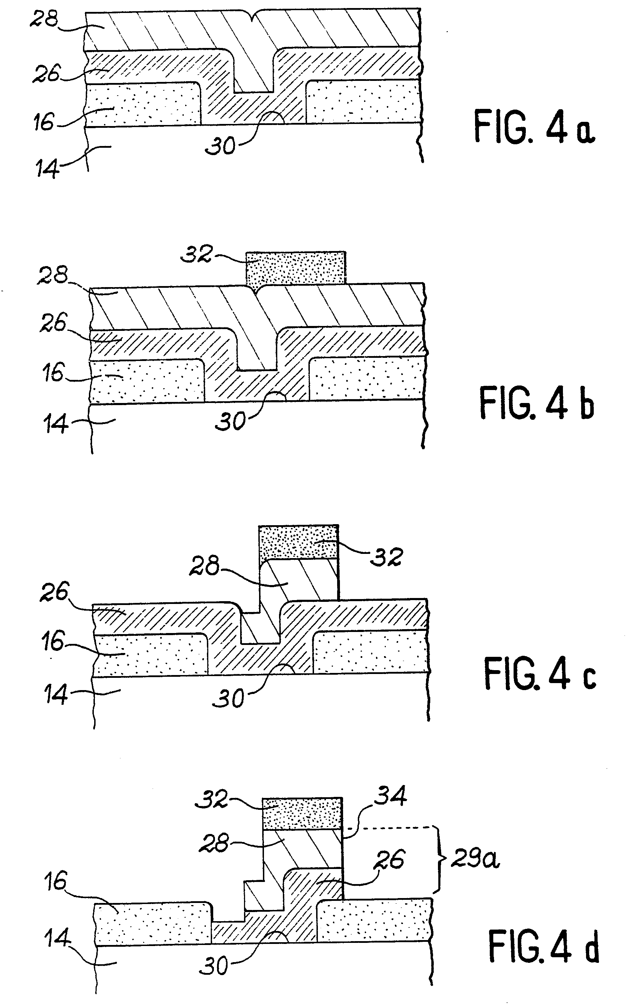

On a représenté sur les figures 4a à 4d un autre mode de mise en œuvre préféré du procédé selon l'invention. Sur ces figures, la ligne d'interconnexion est constituée de deux couches superposées.

Sur la figure 4a, on a représenté une partie d'un circuit intégré comprenant une zone active 14 semiconductrice dopée. Elle est recouverte d'une couche d'isolant 16, par exemple d'épaisseur 0,8 $\mu$. Cette couche 16 est ensuite gravée, par exemple de manière anisotrope par une gravure ionique réactive avec $CHF_3$, de façon à réaliser le trou de contact électrique 30 de la zone active 14. Après réalisation du trou de contact électrique 30, on dépose, de façon connue, sur l'ensemble du circuit intégré, une première couche conductrice 26 déposée par un procédé isotrope. Selon un mode préféré de mise en œuvre du procédé, cette couche conductrice 26 est constituée de silicium polycristallin dopé. Son épaisseur est voisine de 0,4 $\mu$m. Le procédé de dépôt utilisé est dans ce cas un dépôt chimique en phase vapeur. Sur cette couche conductrice 26 on dépose une couche conductrice 28, réalisée de préférence en aluminium. Cette couche conductrice 28 a une épaisseur par exemple voisine de 1 $\mu$m. Elle peut par exemple être déposée par pulvérisation magnétron.

Comme représenté sur la figure 4b, l'étape suivante de procédé de positionnement consiste à déposer une couche de résine 32 dans laquelle on réalise l'image de la ligne d'interconnexion à réaliser selon les procédés classiques de la photolithographie, c'est-à-dire par masquage de la ligne d'interconnexion.

Le masque de résine étant réalisé, il reste à graver les deux couches conductrices pour former la ligne d'interconnexion. La gravure de la couche conductrice 28 réalisée en aluminium se fait de préférence par un procédé de gravure anisotrope utilisant un plasma comprenant par exemple des éléments tels que $CCl_4$. Si la première couche conductrice 26 ne remplit pas le trou, on réalise une surgravure, de préférence légère, de la couche conductrice 28 pour que sa surface libre soit plus basse que la surface libre de la couche conductrice 26. La figure 4c représente une coupe schématique du circuit intégré après cette gravure et cette surgravure.

L'étape suivante est la gravure de la couche conductrice 26. Pour réaliser cette gravure, il faut utiliser un procédé qui n'agit pas, ou pratiquement pas, sur la couche conductrice 28. La gravure de la couche conductrice 26 est ainsi limitée à l'extérieur du trou de contact et au bord de celui-ci où cette couche 26 présente une surépaisseur due à la nature isotrope de son mode de dépôt. Dans le cas d'une couche conductrice 26 en silicium polycristallin dopé et une couche conductrice 28 en aluminium, on peut choisir un procédé de gravure utilisant un plasma composé d'éléments tels que $SF_6$, qui est une gravure anisotrope. Cette gravure est réalisée sur toute l'épaisseur de la couche conductrice 26. Une légère surgravure est ensuite réalisée. On obtient alors une ligne d'interconnexion recouverte par une couche de résine 32 telle que représentée schématiquement en coupe sur la figure 4d. La dernière étape du procédé consiste à éliminer la couche de résine 32, en utilisant par exemple un plasma d'oxygène.

L'avantage d'une ligne d'interconnexion réalisée en deux couches, une couche de semiconducteur dopé, par exemple du silicium polycristallin dopé, et une couche métallique réside dans la diminution de la résistance de contact entre la ligne d'interconnexion et le trou de contact électrique. En effet, cette surface de contact, qui est égale à la surface du trou de contact électrique dans le cas d'une ligne d'interconnexion à une seule couche, est égale dans le cas d'une ligne d'interconnexion bicouche, à la surface de séparation entre la couche semiconductrice dopée et la couche métallique, sur toute la longueur de la ligne d'interconnexion. Un autre avantage réside dans l'élimination des courants de fuite causée, dans une ligne d'interconnexion à une seule couche métallique, par la diffusion des atomes métalliques dans la zone active. D'autres avantages, tels que l'élimination des court-circuits causés lorsque le trou de contact électrique est mal positionné au-dessus d'une jonction, par la mise en contact directe entre la zone active et la couche métallique, apparaissent clairement à l'homme de l'art.

**Revendications**

1. Procédé de positionnement d'une ligne d'interconnexion sur un trou de contact électrique d'un circuit intégré dans lequel, le trou de contact électrique (17, 30) étant réalisé, les bords du trou de contact étant sensiblement perpendiculaires à la surface du circuit intégré, on effectue les opérations suivantes :
dépôt sur l'ensemble du circuit intégré (2) d'au moins une couche conductrice (18, 26, 28), l'ensemble de ces couches conductrices formant un revêtement conducteur, remplissant le trou de contact et présentant une surface sensiblement plane après dépôt, dans lequel sera réalisée la ligne d'interconnexion (18a, 29a), le dépôt de la première couche conductrice (18, 26) étant un dépôt isotrope,
réalisation sur le revêtement conducteur d'une couche de résine (20, 32) de façon à masquer la ligne d'interconnexion (18a, 29a) à réaliser,
réalisation d'une gravure de la partie du revêtement conducteur dépourvue de résine (20, 32),
réalisation d'une surgravure, dans le trou de contact électrique (17, 30) de la partie du revêtement conducteur dépourvue de résine (20, 32),
élimination de la résine (20, 32).

2. Procédé selon la revendication 1, caractérisé en ce que le revêtement conducteur est constitué d'une seule couche conductrice.

3. Procédé selon l'une quelconque des revendications 1 et 2, caractérisé en ce que la gravure de la couche conductrice (18) est une gravure sèche.

4. Procédé selon la revendication 1, caractérisé en ce que le revêtement conducteur est constitué d'une pluralité de couches conductrices (26, 28).

5. Procédé selon la revendication 4, caractérisé en ce que toutes les couches conductrices (26, 28) sont gravées au moyen du même masque.

6. Procédé selon l'une quelconque des revendications 4 et 5, caractérisé en ce que la gravure de la première couche conductrice est sélective par rapport à celle de la deuxième couche conductrice.

7. Procédé selon l'une quelconque des revendications 4 à 6, caractérisé en ce que la gravure de la première couche conductrice (26) est une gravure sèche.

8. Procédé selon l'une quelconque des revendications 4 à 7, caractérisé en ce que la première couche conductrice (26) est une couche de semiconducteur dopé.

9. Procédé selon l'une quelconque des revendications 4 à 8, caractérisé en ce que le revêtement conducteur est constitué de deux couches conductrices (26, 28).

10. Procédé selon la revendication 9, caractérisé en ce que la deuxième couche conductrice (28) est une couche métallique.

**Claims**

1. Process for positioning an interconnection line on an electrical contact hole of an integrated circuit, wherein after the electrical contact hole (17, 30) has been made with the edges of the contact hole substantially at right angles to the surface of the integrated circuit, the following operations are carried out :
deposition on the entire integrated circuit (2) of at least one conductive layer (18, 26, 28), these combined conductive layers forming a conductive covering filling the contact hole and having a substantially plane surface after its deposition, in which covering the interconnection line (18a, 29a) will be formed, the deposition of the first conductive layer (18, 26) being isotropic deposition ;
formation on the conductive covering of a layer of resin (20, 32) in such a manner as to mask the interconnection line (18a, 29a which is to be formed :

effecting the etching of the part of the conductive covering not coated with resin (20, 32) ;

effecting over-etching, in the electrical contact hole of the part of the conductive covering not coated with resin (20, 32) ;

elimination of the resin (20, 32).

2. Process according to Claim 1, characterized in that the conductive covering consists of a single conductive layer.

3. Process according to either of Claims 1 and 2, characterized in that the conductive layer (18) is etched by dry etching.

4. Process according to Claim 1, characterized in that the conductive covering is composed of a plurality of conductive layers (26, 28).

5. Process according to Claim 4, characterized in that all the conductive layers (26, 28) are etched with the aid of the same mask.

6. Process according to either of Claims 4 and 5, characterized in that the etching of the first conductive layer is selective in relation to that of the second conductive layer.

7. Process according to any one of Claims 4 to 6 characterized in that the first conductive layer (26) is etched by dry etching.

8. Process according to any one of Claims 4 to 7, characterized in that the first conductive layer (26) is a doped semiconductor layer.

9. Process according to any one of Claims 4 to 8, characterized in that the conductive covering is composed of two conductive layers (26, 28).

10. Process according to Claim 9, characterized in that the second conductive layer (28) is a metallic layer.

**Patentansprüche**

1. Verfahren zum Positionieren einer Verbindungslinie auf einem elektrischen Kontaktloch einer integrierten Schaltung, bei der das elektrische Kontaktloch (17, 30) ausgebildet wird, wobei die Ränder des Kontaktloches im wesentlichen senkrecht zu der Oberfläche der integrierten Schaltung verlaufen und die folgenden Schritte durchgeführt werden :

Aufbringen wenigstens einer Leitungsschicht (18, 26, 28) auf der integrierten Schaltkreisanordnung (2), wobei die Gesamtheit der Leitungsschichten einen leitenden Überzug bilden, der das Kontaktloch füllt und nach dem Aufbringen eine im wesentlichen ebene Oberfläche aufweist, in der die Verbindungslinie (18a, 29a) ausgebildet wird, wobei das Aufbringen der ersten leitenden Schicht (18, 26) ein isotropes Aufbringen ist, Ausbilden einer Harzschicht (20, 32) auf dem leitenden Überzug derart, daß die herzustellende Verbindungslinie (18a, 29a) maskiert wird,

Ätzen des Teils des leitenden Überzugs, der von dem Harz (20, 32) frei ist,

Nachätzen des Teils des Leitungsüberzugs, der von dem Harz (20, 32) frei ist, in dem elektrischen Kontaktloch,

Entfernen des Harzes (20, 32).

2. Verfahren nach Anspruch 1, dadurch gekennzeichnet, daß der leitende Überzug von einer einzigen Leitungsschicht gebildet wird.

3. Verfahren nach Anspruch 1 oder 2, dadurch gekennzeichnet, daß das Ätzen der Leitungsschicht (18) ein trockenes Ätzen ist.

4. Verfahren nach Anspruch 1, dadurch gekennzeichnet, daß der leitende Überzug von einer Vielzahl von Leitungsschichten (26, 28) gebildet wird.

5. Verfahren nach Anspruch 4, dadurch gekennzeichnet, daß alle Leitungsschichten (26, 28) mittels der gleichen Maske geätzt werden.

6. Verfahren nach Anspruch 4 oder 5, dadurch gekennzeichnet, daß das Ätzen der ersten Leitungsschicht selektiv in Bezug auf dasjenige der zweiten Leitungsschicht ist.

7. Verfahren nach einem der Ansprüche 4 bis 6, dadurch gekennzeichnet, daß das Ätzen der ersten Leitungsschicht (26) ein trockenes Ätzen ist.

8. Verfahren nach einem der Ansprüche 4 bis 7, dadurch gekennzeichnet, daß die erste Leitungsschicht (26) eine dotierte Halbleiterschicht ist.

9. Verfahren nach einem der Ansprüche 4 bis 8, dadurch gekennzeichnet, daß der leitende Überzug von zwei Leitungsschichten (26, 28) gebildet wird.

10. Verfahren nach Anspruch 9, dadurch gekennzeichnet, daß die zweite Leitungsschicht (28) eine Metallschicht ist.

**FIG. 1**

**FIG. 2**

FIG. 3a

FIG. 3b

FIG. 3c

FIG. 3d

FIG. 4 a

FIG. 4 b

FIG. 4 c

FIG. 4 d